Europäisches Patentamt

(19) European Patent Office

Office européen des brevets

(11) Publication number: **0 169 226**
**B1**

(12) **EUROPEAN PATENT SPECIFICATION**

(45) Date of publication of patent specification: **10.01.90**

(21) Application number: **85900702.3**

(22) Date of filing: **21.01.85**

(86) International application number:
**PCT/GB85/00031**

(87) International publication number:
**WO 85/03380 01.08.85 Gazette 85/17**

(51) Int. Cl.⁵: **H 01 G 1/005, H 05 K 1/02,**
**H 05 K 5/04, H 05 K 9/00**

(54) **IMPROVEMENTS IN ELECTRICAL CAPACITORS.**

(30) Priority: **21.01.84 GB 8401618**

(43) Date of publication of application:
**29.01.86 Bulletin 86/05**

(45) Publication of the grant of the patent:
**10.01.90 Bulletin 90/02**

(84) Designated Contracting States:
**GB**

(56) References cited:
**BE-A- 450 586**
**FR-A-2 375 703**
**GB-A- 390 500**
**US-A-2 066 154**
**US-A-2 787 651**

(73) Proprietor: **MORECROFT, Denis Neil**
**42 St. Thomas Road**
**Brentwood Essex CM14 4DF (GB)**

(72) Inventor: **MORECROFT, Denis Neil**
**42 St. Thomas Road**
**Brentwood Essex CM14 4DF (GB)**

(74) Representative: **Dixon, Donald Cossar et al**
**Gee & Co. Chancery House Chancery Lane**
**London WC2A 1QU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to electrical conductors and semi-conductors, for critical current applications. The invention is particularly applicable to capacitors for use in audio systems.

The conductive performance of electrical and electronic components such as capacitors, battery cells, printed circuit boards and other conductors has long been considered relatively predictable and the general design has been straightforward, and most design effort has been expended on miniturisation and improvements in reliability, in capacitors and battery cells at least.

With capacitors it has been known for some time that, in audio applications, they can exhibit imperfect performance when handling complex AC signals, and this cannot be totally explained by their designers, even when all the known and accepted design factors such as dielectric characteristics, leakage, self-inductance, etc., are taken into account. Generally, it is accepted that the larger the value of the capacitance the more evident the problem becomes, and in audio amplifiers a significant degradation in sound quality occurs when large value capacitors are used either for signal coupling or power supply decoupling purposes.

In capacitors, the conducting foil or film which forms the heart of the component, will inevitably have a large surface area, this being required to obtain the desired large capacitance value. The continuity of the large surface area is clearly a problem when the capacitor is being used to transmit AC signals of wide dynamic range and frequency range. Investigations have now indicated that signal degradation is caused by eddy current distortion occuring when low current densities are present in large area conductors.

The eddy currents act to alter the performance of the component indirectly rather than directly; that is, the eddy currents result in a magnetic field which modifies the normal field that produces the back emf opposing the current flow through the component. Therefore, by altering the fidelity of the back emf voltage, the signal can be distored by the eddy currents.

Because of the cylindrical construction methods most frequently used in capacitors, eddy currents can also result in dynamic inductance effects. Self inductance of capacitors is calculated to be fairly small, because the displacement currents which flow during operation are also small. However, any eddy currents which tend to form around the circumference of a large capacitor will dramatically increase the inductance of the component for the time that the current flows.

Further, the crystalline structure of conductive metals is thought to be a cause of signal distortion, and attempts have already been made to produce materials with less crystal boundaries per unit area to improve the performance of those conductors.

In the screening of radio sets, British Patent Specification No. 390500 presents various devices including screens of metal foil exhibiting relatively high electrical resistance and formed with apertures or perforations to increase the effective resistance and consequently reduce eddy currents and their related energy absorption.

It is an object of the present invention to at least reduce the above disadvantages in capacitors incorporating conductive and semiconductive elements.

According to the present invention, an electrical conductor or semi-conductor for alternating current or varying direct current is formed along its length with a plurality of parallel non-contiguous slits which are aligned with the current flow. The slits act to prevent build-up of eddy currents that tend to generate magnetic fields which would interfere with the primary fields created by the primary current and responsible for back emf in the circuit.

The aforementioned slits may be formed by, for example, cutter wheels in metal foil the contact may be conductively complete, or may be reduced as by oxidation in aluminium foil, but in either case the build-up of eddy currents is at least reduced. The slots are formed as cut-outs or in the moulding or other production of the conductive element, and may be straight, curved or of generally oval or other shape; the opposed faces of the slots are spaced apart by a usually small gap.

The formation of slits in, for example, the metal foils in capacitors has resulted in significant improvements in the fidelity of reproduction in audio systems incorporating such capacitors, and preliminary tests have shown comparable improvements in plastics cases coated with conductive shielding against radio-frequency and/or magnetic-field interference with encased components, in conductive elements of printed circuits such as in printed circuit boards, and also in the conductive electrode plates of lead/nickel batteries.

The slits not only control the build-up of eddy currents, but may also effectively reduce crystal boundaries by defining more specific paths for current to flow in large areas of metal such as in large aluminium electrolytic capacitors.

Embodiments of the present invention will now be described, by way of example, with reference to the accompanying diagramatic drawings in which:

Fig. 1 is a perspective view showing a coil of conductive and dielectric foils for use in the production of capacitors;

Fig. 2 is a side view showing a capacitor incorporating the conducting and dielectric foils;

Fig. 3 is a plan view showing alternative arrangements of slits in a conductive element.

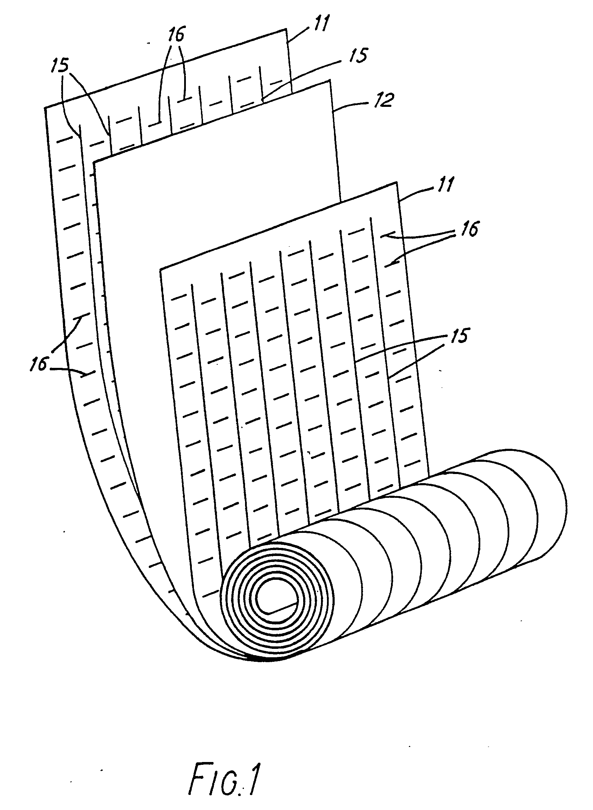

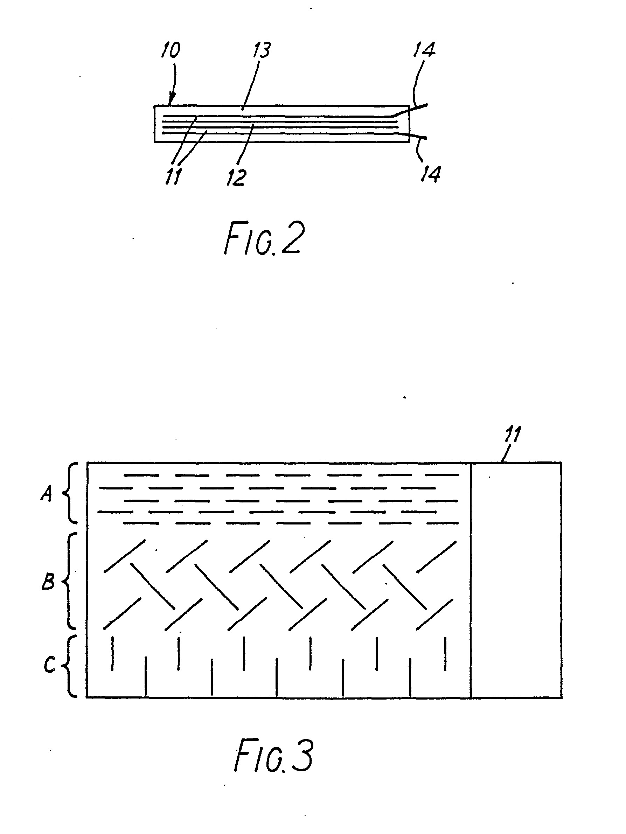

Referring to Figs. 1 and 2, the capacitor 10, which has particular application in high-quality audio equipment, comprises a pair of aluminum foil conductors 11 separated in a conventional manner by a dielectric foil 12. The capacitor has a conventional casing 13 and connectors 14 to the conductors 11.

According to the present invention, each of the foil conductors is formed with slits 15 and 16 as can be seen in Fig. 1. The slits comprise a series of parallel slits 15 extending along the lengths of the foils and in the intended direction of flow of the displacement current, i.e. the current required to feed each unit area of the foil with such a potential as to transfer the charge to the other foil. Further staggered series of short slits 16 extend partly across the strip areas defined by the slits 15.

Tests have shown that capacitors as just described have contributed to audio outputs which are appreciably superior to the output of the same equipment incorporating capacitors which are identical in all respects, apart from the slits 15 and 16.

Fig. 3 shows alternative arrangements of slits intended to produce even better results. The slits of arrangement A give overall improvement, and those of arrangement C improve the capacitor performance but tend to increase effective series resistance. The slits of arrangement B also produce beneficial results, although tests have not yet been completed on all these capacitor foils.

As a result of extensive testing of ranges of capacitors according to the invention, in audio and other equipment and in direct tests on the capacitors themselves, it is believed that the improvements result from the slits preventing or minimising distortion of the back-emf field and so minimise distortion of the primary signals, as hereinbefore mentioned.

It also appears that optimum results can be obtained, at least in capacitors, if the slits are arranged (as in A of Figure 3) to minimise interruption to current flow along the conductor.

Preliminary tests also show that narrow slots, rather than slits, give improved results, and it is envisaged that other cut-out shapes will show improvements over imperforate conductors.

The slits/slots in opposed plates or foils may or may not be in register with each other.

## Claims

1. A capacitor comprising two conducting elements (11) separated by dielectric means (12) and each having an electrical connector (14) to form a circuit through which current will flow, each conducting element (11) comprising a conductive metal foil of low electrical resistance formed along its length with a plurality of parallel slits (A) which are aligned with the current flow between the connectors (14) to prevent build-up of eddy currents.

2. A capacitor as claimed in Claim 1, characterised in that said slits (A) comprise parallel series of non-contiguous slits.

3. A capacitor as claimed in Claim 2, in which the slits of adjacent series are staggered in relation to each other.

## Patentansprüche

1. Ein Kondensator, der zwei durch ein dielektrisches Mittel (12) getrennte leitfähige Elemente (11) umfaßt, von denen jedes mit einem elektrischen Anschluß (14) versehen ist, so daß ein Stromkreis entsteht, durch den Strom fließen wird, wobei jedes leitfähige Element (11) eine leitfähige Metallfolie geringen elektrischen Widerstands umfaßt, die ihrer Länge nach mit einer Vielzahl paralleler Schlitze (A) versehen ist, welche mit dem Stromfluß zwischen den Anschlüssen (14) so ausgerichtet sind, daß der Aufbau von Wirbelströmen verhindert wird.

2. Ein Kondensator nach Anspruch 1, dadurch gekennzeichnet, daß die besagten Schlitze (A) eine parallele Reihe von miteinander nicht in Berührung stehenden Schlitzen bilden.

3. Ein Kondensator nach Anspruch 2, bei dem die Schlitze benachbarter Reihen im Verhältnis zueinander versetzt sind.

## Revendications

1. Un condensateur comprenant deux éléments conducteurs (11) séparés par un moyen diélectrique (12), chacun étant muni d'un connecteur électrique (14) pour établir un circuit destiné à acheminer le courant, dont chaque élément conducteur (11) comporte une feuille métallique conductrice, présentant une faible résistance électrique, et constituée sur toute sa longueur d'une succession de fentes parallèles (A) qui sont alignées sur le flux de courant entre les connecteurs (14) afin d'éviter toute formation de courants de Foucault.

2. Un condensateur selon la revendication 1, caracterisé par le fait que lesdites fentes (A) constituent des séries parallèles de fentes non contiguës.

3. Un condensateur selon la revendication 2, dans lequel les fentes de séries adjacentes sont décalées les unes par rapport aux autres.

FIG.1

1

FIG.2

FIG.3